# EUROPEAN PATENT SPECIFICATION

(11) **EP 1 491 960 B1**
(45) Date of publication and mention of the grant of the patent: **25.04.2012**
(21) Application number: 04076581.0
(22) Date of filing: 28.05.2004
(51) Int. Cl.: G03F 7/20

(54) **Lithographic apparatus**
Lithographischer Apparat
Appareil lithographique

(30) Priority: 30.05.2003 EP 03076673
(43) Date of publication of application: 29.12.2004
(73) Proprietor: ASML Netherlands B.V., 5504 DR Veldhoven (NL)
(72) Inventor: Molenaar, Jacobus Frederik, 3571 AE Utrecht (NL); Van Eijk, Jan, 5644 DL Eindhoven (NL); Van den Hoven, Gerbrand Petrus Johannes, 5421 GC Gemert (NL); Pardoel, Michel Gerardus, 5731 EA Mierlo (NL); Vervoordeldonk, Michael Johannes, 5246 JC Rosmalen (NL); Verdoes, Gerardus Johannes, 5632 LR Eindhoven (NL); Verweij, Antoine Hendrik, 4271 AZ Dussen (NL)
(74) Representative: Maas, Abraham Johannes

(56) References cited:
- EP-A- 0 744 663
- US-A- 4 589 769
- US-A- 5 390 227
- US-A- 5 600 698
- US-A- 5 889 758
- US-B1- 6 259 509
- US-B1- 6 307 619
- US-B1- 6 388 733

## Description

The present invention relates to a lithographic projection apparatus comprising:
- an illumination system for providing a projection beam of radiation, wherein said illumination system defines a focal plane through which, in use, said projection beam passes;
- a support structure for supporting a patterning means at a location, the patterning means serving to pattern the projection beam according to a desired pattern;
- a masking device for obscuring at least a part of said patterning means from said projection beam, said masking device comprising a first masking means arranged to obscure said part in a first direction with respect to said location and a second masking means arranged to obscure said part in a second different direction with respect to said location;
- a substrate table for holding a substrate;
- a projection system for imaging the patterned beam onto a target portion of the substrate. Such an apparatus is, for example, known from EP 0 744 663 and US 6,259,509.

The term "patterning means" should be broadly interpreted as referring to means that can be used to endow an incoming radiation beam with a patterned cross-section, corresponding to a pattern that is to be created in a target portion of the substrate; the term "light valve" has also been used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required addressing can be performed using suitable electronic means. More information on such mirror arrays can be gleaned, for example, from United States Patents US 5,296,891 and US 5,523,193.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and US Serial No. 09/180,011, filed 27 February, 1998 (WO 98/40791).

Lithographic projection apparatus can be used, for example, in the manufacture of integrated circuits (ICs). In such a case, the patterning means may generate a circuit pattern corresponding to an individual layer of the IC, and this pattern can be imaged onto a target portion (comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

It is often desirable or necessary to ensure that only a certain part of the mask is imaged by the projection beam to the substrate. For example, the mask may contain more than one pattern of which only one is used for a given exposure. It is also often desirable or necessary to stop stray light from impinging on the substrate. In lithographic projection systems using this function it is typically achieved by providing a mask masking device at an intermediate plane in the illuminator.

In a stepper system where the mask is fixed with respect to the illuminator, the mask masking device is provided adjacent the mask and is also fixed with respect to the illuminator and the mask.

Conventional masking devices comprise at least one movable blade. In certain conventional devices two sets of moveable blades are provided. Conventionally the two sets of blades are mechanically coupled to a support and each support is mounted on a common frame. Thus conventionally the sets of blades are mechanically coupled to each other. Conventionally, the two sets of blades may be disposed in a plane in the illumination unit. Each set of moveable blades comprise a pair of blades arranged to move together and apart in one direction, the Y-direction, hereinafter referred to as the Y-blades, and the other pair of blades is arranged to move together and apart in a direction perpendicular to the Y-blades, in the X-direction, hereinafter referred to as the X-blades. There are currently two types of mask masking schemes: masking for static exposure and masking for scanning exposure. In static exposure, part of the mask is blocked for the duration of an exposure. In scanning exposure, a part of the mask is blocked for a predetermined length of time.

The blades may be set so that there is a predetermined distance between the X-blades and the Y-blades, respectively. Conventionally, the Y-blades are arranged to be moveable during scanning, and the X-blades, although moveable, are generally arranged to be stationary during scanning. If the X-blades are to be moved, this generally takes place in between scans. For static exposures the X-blades may be moved between exposures. For scanning exposure, Y-blades in particular are arranged to perform additional movements to allow scanning of the patterning means by the radiation source to take place. Before a scanning cycle begins, the blades are arranged to prevent any radiation impinging on the patterning means. At the beginning of the scanning cycle the Y-blades open to a scanning distance. At the end of the scanning cycle, the Y-blades, in particular, move into a position in which light is prevented from impinging on the patterning means, so that at the end of the scanning cycle no light impinges on the patterning means.

The inventors have found that problems arise with conventional masking devices. For example, problems arise when the masking devices are arranged to scan the mask. As higher scanning speeds are demanded, conventional masking devices fail. In particular, with some conventional masking devices the mass of the coupled X-Y blades creates inertia, preventing the Y-blades from being able to be accelerated and decelerated fast enough to open to their scanning position, and close at the end of the scan position, respectively. Further, the high moving mass cannot be satisfactorily moved at high enough scanning speeds by conventional motors without causing disturbances to be transferred to other parts of the apparatus.

It is an object of the present invention to provide an apparatus and method which can effectively mask portions of the mask of a lithographic projection apparatus during scanning as well as static exposure.

This and other objects are achieved according to the invention in a lithography apparatus as specified in the opening paragraph, characterized in that said first and second masking means are disposed in the vicinity of said focal plane in a mechanically uncoupled arrangement with respect to each other and each of said first and second masking means is supported on respective separate first and second support members, wherein the second support member comprises a gas bearing surface and an opening and in use gas is leaving the opening to create a gas bearing between the gas bearing surface and a moveable blade provided to the second masking means to support the blade.

This arrangement provides an advantage in that the first and second masking means are isolated from one another whilst providing an effective masking function. A further advantage being that vibrations and disturbances from the first masking means and the apparatus frame do not disturb the second masking means, and vice versa. The uncoupled masking means have a lower mass than the coupled masking means. Thus, lower driving forces are required to move the masking means enabling higher accelerations and scanning speeds to be achieved.

According to a further aspect of the present invention, there is provided a lithographic projection apparatus, wherein said first masking means is provided with a cooling device.

This arrangement provides the advantage in that the cooling of the first masking means enables the dimension of a first set of blades of the masking means in the direction of the projection beam (the thickness) to be reduced in comparison with conventional blades. The thinner first set of blades takes up less room in the region of the focal plane than conventional blades enabling a second set of blades to also be disposed within proximity of the focal plane, yet still provide good masking with sharp edges.

According to a further aspect of the invention there is provided a device manufacturing method comprising the steps of:
- providing a substrate that is at least partially covered by a layer of radiation-sensitive material;
- providing a projection beam of radiation using an illumination system;
- providing a support structure for supporting a patterning means at a location, the patterning means serving to pattern the projection beam according to a desired pattern;
- selectively obscuring part of at least one of said patterning means from said projection beam and the patterned beam, using a first masking means to selectively obscure said part in a first direction with respect to said location, and using a second masking means to selectively obscure said part in a second different direction with respect to said location,
- projecting the patterned beam of radiation onto a target area of the layer of radiation-sensitive material, characterized by
disposing said first masking means and second masking means in the vicinity of a focal plane of said projection beam in a mechanically uncoupled arrangement with respect to one another; supporting each of said first and second masking means on respective separate first and second support members, and providing gas through an opening in a gas bearing surface of the second support member to create a gas bearing between the gas bearing surface and a blade provided to the second masking means to support the blade.

In a manufacturing process using a lithographic projection apparatus according to the invention a pattern (e.g. in a mask) is imaged onto a substrate that is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target area", respectively.

In the present document, the terms "radiation" and "beam" are used to encompass all types of electromagnetic radiation, including ultra-violet radiation (e.g. with a wavelength of 365, 248, 193, 157 or 126 nm) and extreme ultra-violet (EUV) radiation (for example, having a wavelength in the range of 5-20 nanometres), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 shows a masking device according to an embodiment of the invention;
Figure 3a shows a three dimensional overview of a masking device according to an embodiment of the invention;
Figure 3b shows a cross section in the YZ plane of part of the lithographic apparatus shown in Figure 1 showing masking blades according to an embodiment of the invention;
Figure 4 shows a cross section in the YZ plane of part of the lithographic apparatus shown in Figure 1 showing stacking of masking blades according to an embodiment of the invention;
Figure 5 shows X-blades of the masking device mounted on a support member according to an embodiment of the invention;
Figure 6 shows detail of a X-blade mounted on a support member according to an embodiment of the invention;
Figure 7 shows a plan view of a support member for Y-blades according to an embodiment of the invention; and
Figure 8 shows details of a Z manipulator integrated in an X and Y assembly supporting frame according to an embodiment of the invention.

In the Figures, corresponding reference symbols indicate corresponding parts.

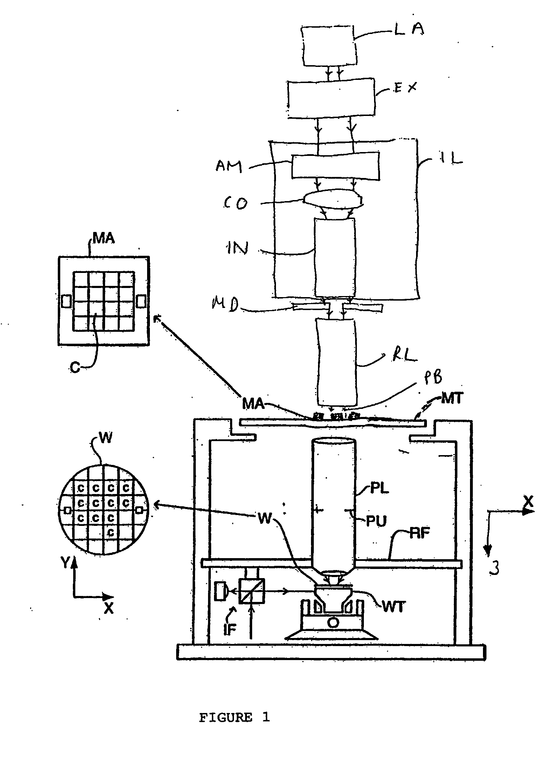

Figure 1 schematically depicts a lithographic projection apparatus according to a particular embodiment of the invention. The apparatus comprises:
a radiation system Ex, IL for supplying a projection beam PB of radiation (e.g. UV radiation). In this particular case, the radiation system also comprises a radiation source LA;
. a masking device MD provided for selectively shielding parts of a mask MA (eg. a reticle) from the proj ection beam, in other embodiments, masking device may be provided to selectively shield parts of the patterned projection beam;
a relay optics RL provided for projecting the radiation that passes through the masking device to the mask MA;
a first object table (mask table) MT provided with a mask holder for holding the mask MA, and connected to first positioning means for accurately positioning the mask with respect to item PL;
a projection system ("lens") PL (e.g. a projection lens) for imaging an irradiated portion of the mask MA onto a target portion C (comprising one or more dies) of a substrate W: and
a second object table (substrate table) WT provided with a substrate holder for holding the substrate W (e.g. a resist-coated silicon wafer), and connected to second positioning means for accurately positioning the substrate with respect to item PL.

As here depicted, the apparatus is of a transmissive type *(i.e.* has a transmissive mask). However, in general, it may also be of a reflective type, for example (with a reflective mask). Alternatively, the apparatus may employ another kind of patterning means, such as a programmable mirror array of a type as referred to above.

The radiation system may comprise a source LA (e.g. a mercury lamp, a Krypton-Fluoride excimer laser or a plasma source) that produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as a condenser CO and an integrator IN. The condensor CO projects the incoming light to the integrator IN. The integrator IN may, for example, be formed of a quartz rod, and is used to improve the intensity distribution of the beam to be projected over the cross section of the beam. The integrator IN thus improves the illumination uniformity of the projection beam PB. In this way, the beam PB impinging on the mask MA has a desired uniformity and intensity distribution in its cross-section.

The radiation system may further include a relay optics RL. The relay optics are preferably a sealed assembly mounted in the lithography apparatus and contains expansion optics, a mirror for directing the projection beam toward the mask, a further condensor lens and a projecting lens. The function of the relay optics RL is to image the masking device "image" plane on the reticle mask "focus" plane. The relay optics RL is optional. Its main functions are to image the blades of the masking device with a sufficiently small edge width, match the entrance pupil function of the projection lens, and provide a uniform illumination of the mask.

It should be noted with regard to Figure 1 that the source LA may be within the housing of the lithographic projection, but that it may also be remote from the lithographic projection apparatus, the radiation beam which it produces being led into the apparatus (e.g. with the aid of suitable directing mirrors). The current invention and claims encompass both of these scenarios.

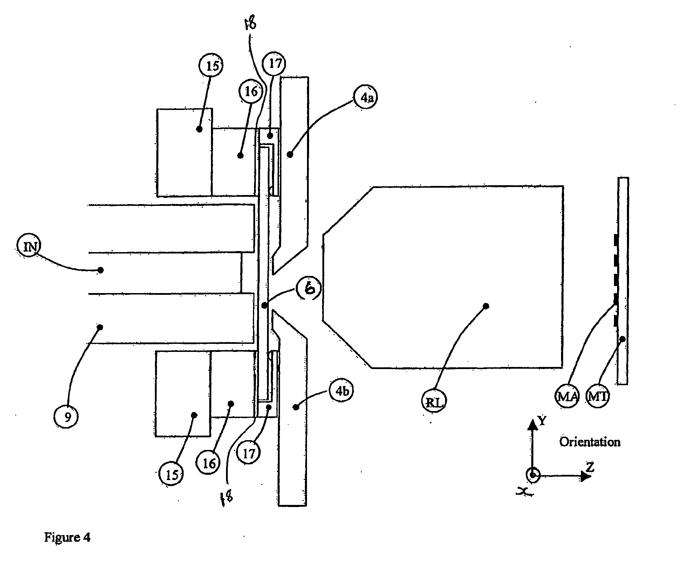

In Figure 1, the masking device MD is disposed between the illuminator IL and the relay optics RL. However, as shown in Figure 4, the masking device MD may instead be disposed directly above the mask MA. The masking device MD is a spatial filter. Those parts of the projection beam falling on the masking device will be preferably reflected or absorbed. Only those parts of the projection beam not falling on the masking device will be transmitted. The masking device projects a "slit" on to the mask. As discussed below, the masking device is controllable to control the dimensions of the slit through which the projection beam passes.

Either directly after passing through the masking device MD, or subsequent to passing through the relay optics RL, the beam PB intercepts the mask MA which is held in a mask holder on a mask table MT. Having been transmitted through (or reflected by in the case of a reflective mask) the mask MA, the beam PB passes through the projection system PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long stroke module (coarse positioning) and a short stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go *(i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the Y-direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M=* 1/4 or 1/5). In this manner, a relatively large target portion C can be exposed, without having to compromise on resolution. The present invention is particularly applicable to the scan mode. However, the invention is not limited in terms of its applicability to synchronous scanning where the masking device is arranged to move together with the patterning means or to synchronous scanning where the movement profile of the masking device differs from that of the patterning means.

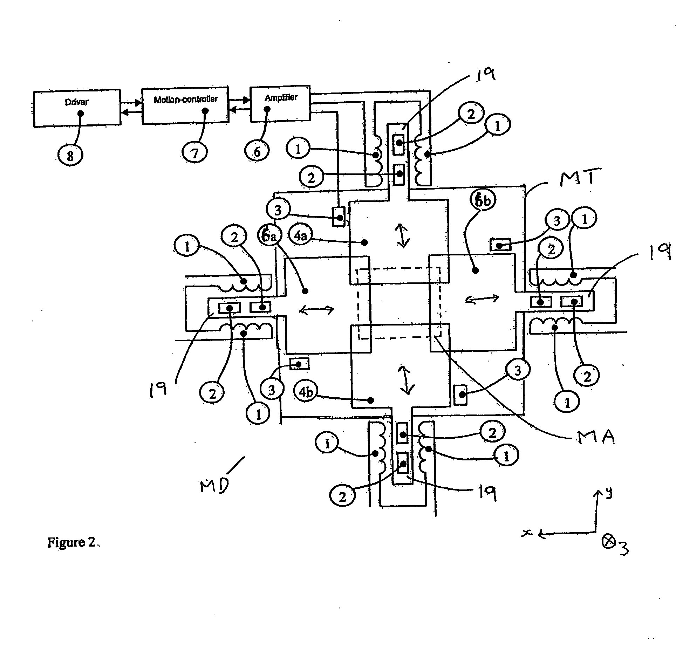

Figure 2 shows a masking device according to an embodiment of the invention. The masking device MD comprises a first masking means and a second masking means. The masking means may be plates or blades or other constructions suitable for selectively obscuring the location at which the patterning means, when in use, is located. The masking device preferably comprises blades 4a, 4b, 6a, 6b, which preferably are arranged to form two sets of blades: the X-blades and the Y-blades. The two sets of blades are mechanically uncoupled with respect to one another. That is to say that the blades are mounted in such a manner that a vibration generated in either an X or Y blade is not transmitted to a Y or X blade, and vice versa. The mounting of the X and Y blades is described in more detail hereinafter. The blades may also be considered as being plates or other constructions suitable for obscuring. According to one embodiment of the invention, the Y blades 4a and 4b are driven, whilst the X-blades 6a and 6b are stationary during exposure. However, the invention is not limited in this respect and the Y-blades may be stationary, or the X-blades may be moveable while the Y-blades are stationary. The blades which move during scanning, hereinafter referred to the Y blades are controlled by software and electronics. The X-blades are similarly controlled with software and electronics. It is noted that according to the currently observed convention, the Y-blades move together and apart in the Y-direction, the Y-direction also being the scanning direction, i.e. the direction in which the mask table and the substrate table are moved in a scanning exposure. The moving blades are controlled to move according to a desired scanning profile. At the end of a scanning cycle, the blades are arranged to block the light source, thus preventing the light source from impinging on the patterning means. When a scanning cycle begins, the blades are controlled to move so that the light source impinges on the patterning means. The dimensions of the light source determine what is referred to as the scanning slit. The dimensions of the scanning slit are, in particular, determined by the optical source and the quartz rod. The scanning slit width in the Y-direction, which is conventionally the scanning direction, is variable and will be chosen depending on factors such as the dimensions of the mask to be exposed. The blades are accelerated to the scanning width as quickly as possible. Typical accelerations of the blades are in excess of 10 m/s/s and up to the region of 45m/s/s. In an open position, the Y-blade assembly is scanned at a predetermined scanning speed, typically in excess of 500mm/s, across the mask. Once the mask has been scanned, the blades are moved to be arranged so as to block the light source, and thus prevent the light source impinging on the patterning means. This may be done, for example, by accelerating the open blades towards each other, in order to block the slit as quickly as possible. Alternatively, only one of the blades may be moved in the scanning direction to block the slit. For example, the trailing blade may be moved in the direction of the scan or the leading blade may be moved in the direction opposite to the scanning direction towards the trailing blade. The movements of the blades are not however limited to the example described above, and the blades of the present invention may be controlled to move according to any predetermined scanning profile. If desired, the blades may also be held stationary, either closed or at a constant slit width.

The control means for the blades includes a driver 8 for generating high level commands, which are fed to a motion controller 7. Typically, the driver 8 is a software driver. From the high level commands, the programmable motion controller 7 generates control signals which are fed to an amplifier 6 which generates a current in accordance with the control signals to drive motor windings 1. Also provided is a position measurement device 3, which provides data concerning the position of the blades 4a,4b,6a,6b. This data is fed back via the amplifier 6 to the motion controller 7.

At least a part of the motor to drive the blades is incorporated into the blades or the blade support member. It is seen in Figure 2 that each blade is provided with a motor 1,2 and a positioning measuring means 3. The motor 1,2 comprises at least one motor winding 1, which does not come into contact with the blade it drives, and a magnet 2. The magnet is mounted directly on an intermediate portion 19 around which the motor windings 1 are disposed. The intermediate portion 19 on which the magnet 2 is disposed resembles a "pan handle" of the blade support member for the X blades, and for the Y blades the magnet is integrated at the rear end of the blades, that is the end remote from the optical blade edge. The intermediate portion may be constructed out of the same material as the blade, however this is not essential. Also, it is not essential that the blade and the intermediate portion 19 be constructed from a single piece of material.

Preferably, the blades are supported by blade support members. Preferably, the blade support members for the Y-blades comprise non-contact bearings. The motors 1,2 described above are preferably non-contact linear motors. These features reduce the moving mass of the blades and enhance durability. Further the use of non-contact bearings and motors reduce frictional forces, which in turn allows the blades to be subject to higher accelerations without causing disturbances to other components in the system. This also results in improved accuracy of the blade mobility, with the blades being able to be moved at higher speeds and accelerated at higher accelerations.

In Figure 2 the action of the driver 8 is translated to the blades via the intermediate portion 19. The motor coils are preferably provided on the blade support and are arranged to surround the intermediate portion 19, rather than on the blades as is conventional. This arrangement provides the benefit that there are no moving cables and hoses, because the heat generating coils are disposed on a fixed frame. Thus, a longer lifetime is achieved. This arrangement provides the additional benefit that no cables are required to be connected to the moving parts, there is no cross talk between motors driving the moving parts, and the lifetime of the apparatus is increased. Preferably, magnet 2 is provided with the blade(s) which responds to the drive signal. It has been demonstrated that blades constructed and driven according to the present invention can support scanning at the wafer stage at speeds up to 550 millimetres per second, and can further be subject to a blade acceleration of 45metres/second/second whilst maintaining a tracking error of less than 10 micrometres. By reducing the number of moving parts in the drive mechanism and on the blades themselves an improved reliability has been observed. Also, slip for example, between moving parts has been eliminated.

Also, to be seen in Figure 2 is a plan view of the mask table MT (and mask MA) showing its location relative to an embodiment of the masking device. The mask table MT is itself movable by means of positioning means (not shown).

In an embodiment, the masking device may be provided on the mask table MT and so the masking device MD moves with the mask table MT because it is mechanically coupled to it. In other embodiments, the masking device MD may be coupled electronically, magnetically or electrostatically to the mask table MT. Preferably, the masking device is demountable. Alternatively, the masking device MD can be coupled to the long-stroke or short-stroke module of the positioning means PM rather than the mask table MT itself.

In Figure 2, two pairs of blades 4a,4b,6a,6b are used to provide selectivity in terms of the extent the mask MA (or the patterned beam) is obscured using the masking device MD and are moveable in the directions indicated by the arrows. As can be seen from Figure 2, the two blades 4a,4b are mounted perpendicularly to the blades 6a,6b via non-contact linear motors 1,2. The blades 4a,4b move together and apart in the Y-direction (Y-blades) and the blades 6a,6b move together and apart in the X-direction (X-blades). In Figure 2 all four blades may be coupled via the motion controller 7 and the driver 8 to the motion controller and driver of the patterning means.

As previously described, it can be seen therefore that the blades in general perform two types of movements. The first are movements to block or unblock one of the light source impinging on the patterning means or patterned beam. These movements include closing/opening movements in which the two blades of a pair move relative to one another so as to adjust the part of the mask or patterned beam which is obscured. The second are tracking movements in which both blades of a pair move by the same vector so as to keep track of movements of the mask table. As already discussed, the tracking movements are carried out automatically when the blades are coupled directly to the mask table.

It is further added that in the embodiments shown in Figures 1-4, during scanning, the X-blades are stationary. However, the X-blades are not limited in this respect. Motors are provided in order to move the X-blades with respect to one another.

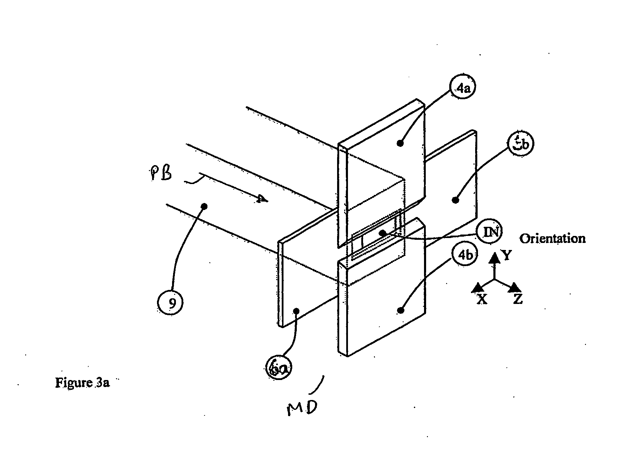

Figure 3a shows a three dimensional overview of the masking device MD. In particular it is seen how the X-blades 6a,6b and Y-blades 4a,4b are disposed with respect to the integrator housing 9 (comprising, eg. integrator IN). In Figure 3a, in the direction of the projection beam PB, the Y-blades 4a,4b are disposed downstream of the X-blades 6a,6b. In the embodiment shown, the X-blades are constructed to withstand the thermal impact of the projection beam PB. However, in an alternative embodiment, the Y-blades 4a, 4b may be disposed upstream of the X-blades 6a,6b. Figure 3a enables the shapes of the slit forming blades to be seen.

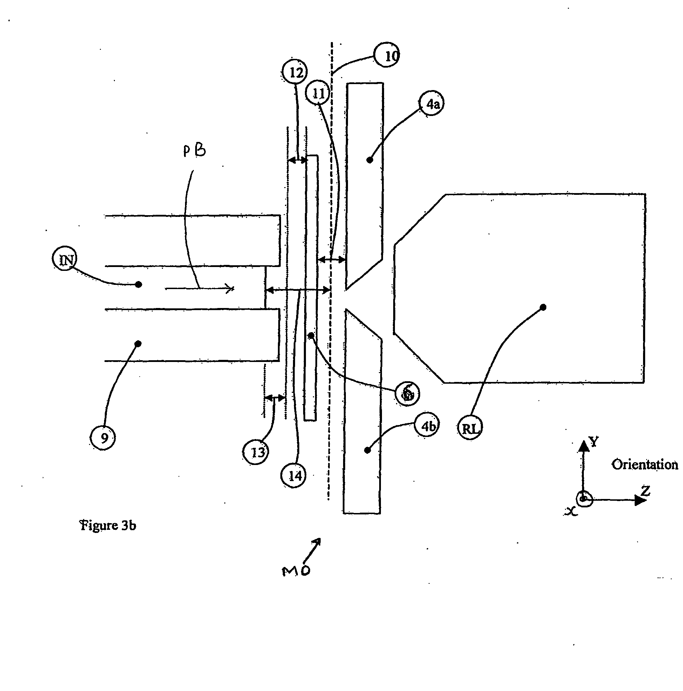

Figure 3b shows a cross section in the YZ plane of part of the lithographic apparatus shown in Figure 1 showing the masking device MD according to an embodiment of the invention.

With reference to Figure 3b, the masking device of the present invention, in particular features of the blades, and their arrangement with respect to each other and other components of the lithographic apparatus are described in further detail. According to certain aspects of the present invention, the construction and arrangement of the two sets of blades results in a decoupling of the two sets of blades from one another and from mechanical coupling of the blades to the frame. In an embodiment of the invention, the blades float on air bearings, rather than being mechanically coupled to the frame. Thus, the Y blades, in particular, are not subject to disturbances from the X-blades or from the frame, such as vibrations. In particular, and in contrast to conventional masking devices, the X and Y blades are constructed to be arrangeable so that their position and mobility is not directly determined by the position and mobility of the other set of blades. Uncoupling the blades results in a minimization of the moveable mass. Whereas conventional movable blades weigh in excess of 600 grammes, blades according to the present invention weigh in the order of 100 grammes. This has been achieved by the use of *inter alia* a direct drive, where the magnets of the driving motor are integrated into the blade or blade support member, and the mechanical decoupling of the two sets of blades from each other.

Figure 3b shows the integrator IN, which is preferably a quartz rod, mounted in integrator housing 9. Also shown is the masking device MD disposed downstream of the integrator IN in the direction of the projection beam PB. A portion of the relay optics RL is also shown disposed downstream of the masking device MD. The mask MA (not shown) to be exposed is disposed downstream of the relay optics in the direction of the projection beam PB. The masking device MD comprises two sets of blades 4, 6 arranged to selectively obscure part of the mask MA from the radiation beam. The Y blades 4 are movable together and apart in the Y-direction, which is also the direction of scanning of the mask. In principle, the X-blades 6 are not moved with respect to each other during a scan. Thus, the distance between the X-blades during a scan is constant. However, the X-blades 6 may be moved with respect to each other if required by the scan profile, as determined by the width of the image on the mask.

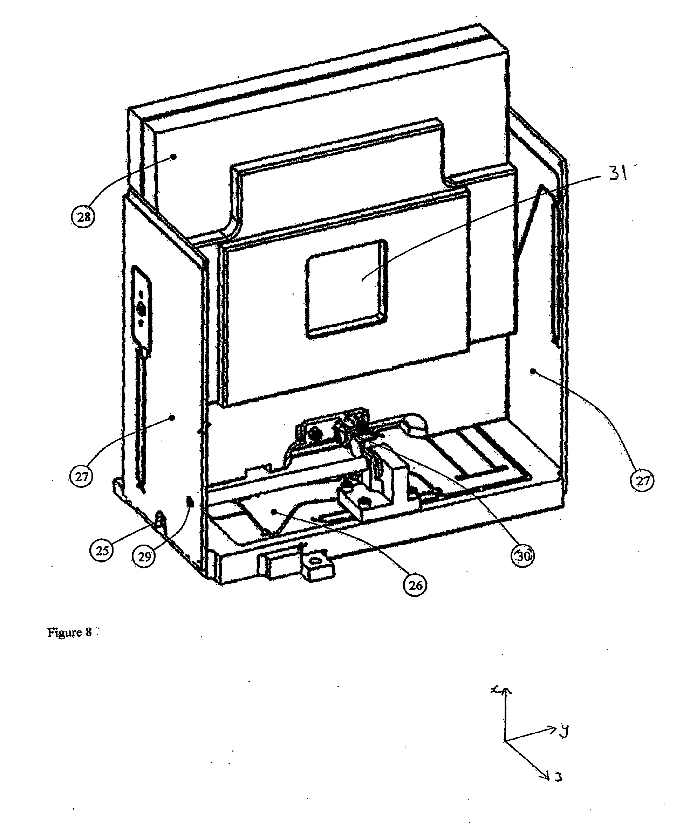

It will be appreciated that the position of the masking device with respect to the radiation system and the mask is important. The radiation system LA, Ex, IL generates a beam having a focal plane 10, corresponding to a plane substantially conjugate to the filed plane of the mask, at a predetermined location depending on the optical components of the radiation source, illuminator and relay optics. Although Figure 3b shows the focal plane at location 10, the focal plane may vary. In which case adaptation of the position of the blades in the Z-direction with respect to the focal plane may be necessary, preferably, using a Z manipulator as shown in Figure 8.

In conventional masking devices, all blades have a certain thickness which is necessary in order for the mechanical stability of the blades and for them to be able to withstand the thermal load which the blades are subjected to by the radiation which they block. A consequence of this is that in conventional masking devices all blades are coupled together and must be disposed in the focal plane of the beam. Conventionally, it is not possible to decouple the X and Y blades because their thickness precludes them from both being disposed within the critical limits of the focal plane. The inventors of the present invention have found that it is possible to dispose the blades not directly in the focal plane yet still be able to project sharp optical edges of the slit onto the mask. In particular, if the end of the quartz rod is disposed at one end of the margins of the focal plane in the Z-direction and the Y-blades are disposed at the opposite end of the margin in the Z-direction, it has been found that space is provided to dispose the X-blades in a mechanically decoupled manner from the Y-blades, whilst still allowing a sharply focused slit to be projected on to the patterning means. Preferably, however, for optimum masking the blades are disposed within a certain distance of the focal plane 10 of the beam, which is preferably in the order of 50 micrometers.

In Figure 3b, the stationary blades 6, also referred to as the X blade, are preferably disposed at a distance less than 200 micrometres, and preferably within a distance 11 of approximately 100 micrometres from the movable blades 4. The focal plane 10 in the example shown lies between the stationary and the movable blades. Associated with the integrator IN are tolerances. The distance between the downstream end plane of the quartz rod of integrator IN and the integrator housing 9 plus tolerances is shown by arrow 13. The stationary blades are disposed a distance 12 from the end of the quartz rod plus tolerances 13. Preferably, the distance 12 is less than 100 micrometres. The distance between the end of the quartz rod and the focal plane of the beam is shown by arrow 14, and is typically of the order of 300 to 600 micrometres.

It is seen from Figure 3b that the stationary during scanning (or X) blades are of a thinner construction than the movable during scanning (or Y) blades and that the stationary blades are disposed in the beam upstream of the movable blades. This construction is discussed in more detail hereinbelow. The invention is not limited to the example given below. It is envisaged that the stationary during scanning blades may alternatively be thick and the moving during scanning blades may alternatively be thin.

The masking device, and in particular the blades, are subject to large thermal stress from the projection beam radiation. As mentioned above, the thermal load on the blades is a reason why blades in conventional masking devices have a large thickness, of the order of 1 to 3 millimeters. In addition, cooling of conventional blades is limited. The energy of the radiation blocked by the masking device is a problem for masking devices because it can affect the apparatus components and the blades themselves. To address this problem, the blades may be provided with a surface which is reflective to the projection beam radiation. In the particular example, the blades are provided with an ultra violet reflecting coating. This alone however, may not be sufficient, and in addition, may not be permitted for all light source wavelengths envisaged to be used with the present invention.

It has been found that by providing sufficient cooling means to the blades, in particular, to the upstream blades, in the example shown in Figure 3b, in other words the stationary X-blades, the thickness of the blades can be reduced. In one embodiment, the stationary blades are asymmetrically cooled with respect to the moving blades, i.e. the amount of cooling applied to the stationary, or upstream, blades is different from that applied to the other set of blades, and preferably the amount of cooling is greater. It has further been found that by cooling the X-blades to a sufficient degree, the thickness of the X blades can be reduced. If the cooling is sufficient, the X-blades are made sufficiently thin, so that there is enough space to allow the Y-blade to be downstream of the X-blade whilst still lying within the sufficiently small distance of the focal plane to allow a sufficiently sharp slit to be projected onto the patterning means.

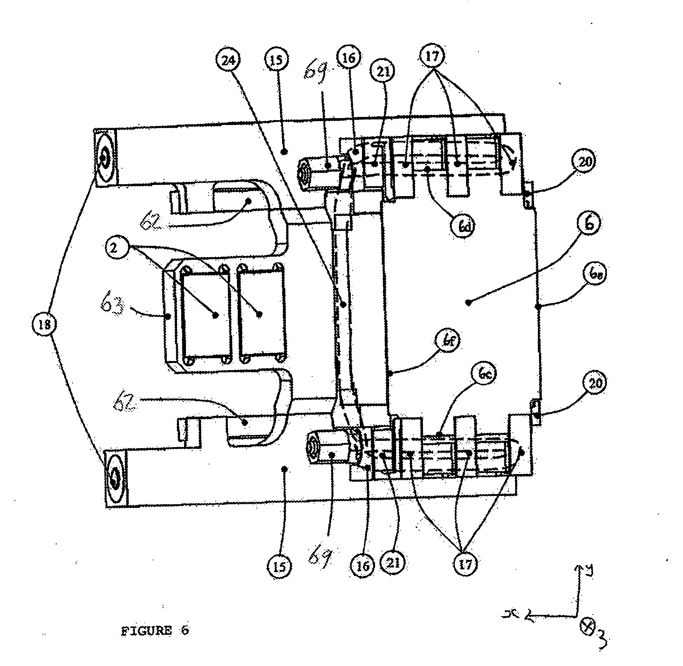

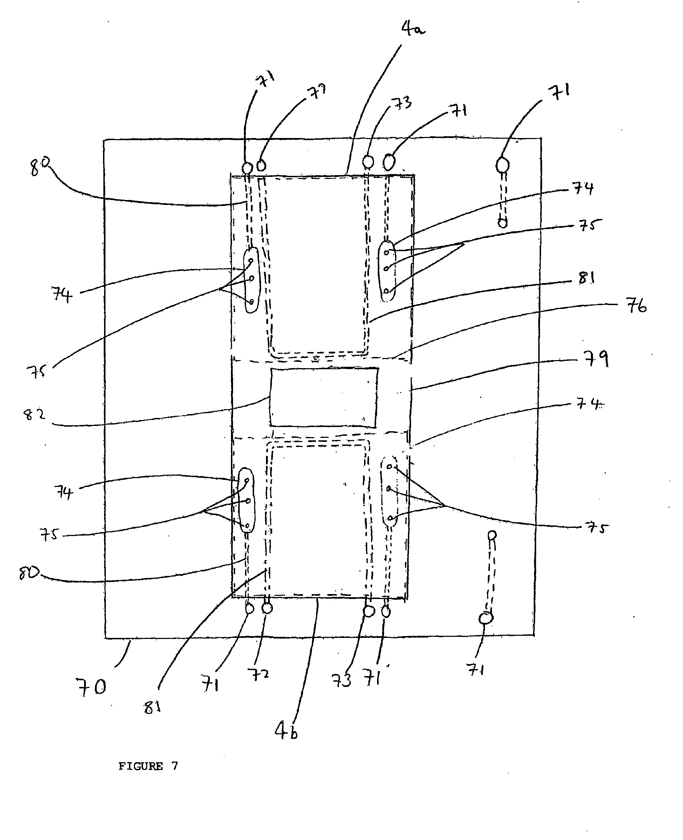

According to a preferred embodiment of the present invention cooling ducts are provided in the blade support member. Such ducts allow conventional air hoses to be dispensed with. The ducts may have various configurations and may be used for supplying various coolants, such as air and/or water, in order to cool. For cooling, ducts are provided in the blade support member. Coolant is fed from an inlet provided on the support member to an outlet via the ducts. The outlet preferably comprises an opening provided in the support member. The ducts are preferably disposed adjacent the blade to be cooled. The water is circulated via the ducts underneath the blades to an outlet also preferably provided on the frame. Cooling of the masking device MD is described in more detail with reference to Figures 6 and 7 below.

In view of the harsh environment in which the blades are disposed, the choice of material for the blades, in particular, the X-blade is important. The choice material for the X and Y blades provides an optimum combination of thermal expansion co-efficient (alpha), thermal conductivity (lambda), wear resistance and reflection co-efficient for ultra violet and deep ultraviolet radiation. Accordingly, blades shown in the figures may be made of, for example, a ceramic or diamond material. Preferred materials for the blades are chemical vapour deposition diamond (CVD diamond), aluminium, tungsten copper alloy and silicon carbide, all of which exhibit a good combination of the required properties. In particular, CVD diamond is preferred. The thickness of the X-blade is preferably in the order of approximately 0.4mm in the direction of the projection beam. In addition to those properties mentioned above, it is important that the material of the X-and Y-blades has a high Young's modulus and low density, in order that the blades whilst being stiff are as light as possible, in order to reduce the moving mass of the blades. The Y-blade shown in the figures may be made of, for example, aluminium or an aluminium beryllium alloy (AlBe). Preferred materials for the Y-blades include metal matrix composites, ceramics, diamond, beryllium alloys and graphite. The thickness of the Y blades is in the order of 6mm. However, in addition to those materials mentioned above, the blades can also be made of any appropriate material, which in general comprise materials that can withstand the radiation, are rigid and lightweight, or can be provided with coatings having these properties. Further, some materials, such as certain ceramics have the advantage that it can include one or more cooling channels in it, as described in European Application Number 00304336.1 (applicant's ref: P-0183).

It has been found that an anti reflective coating on non-polished surfaces of the blades cuts down unwanted reflections in the masking device assembly. This results in an improvement in the accuracy of the patterning of the beam.

Figure 4 shows a cross-section of the masking device of Figure 2 in the Y-Z plane. In particular, Figure 4 shows the stacking of the X and Y blades. The X-blade 6 is shown in plane. The masking device MD is disposed above the mask. In addition in Figure 4, it is seen that the X-blade 6 is mounted on a blade support member 15, on which a heat sink 16 is provided. A clamping device 17 is provided to clamp the X blade to the heat sink 16, so that good thermal contact between the X blade and the heat sink promotes cooling of the X blade. In one embodiment, the masking means comprises a blade mounted on the blade support, wherein a layer 18 of material having a high thermal conductivity is disposed between said blade and said blade support.

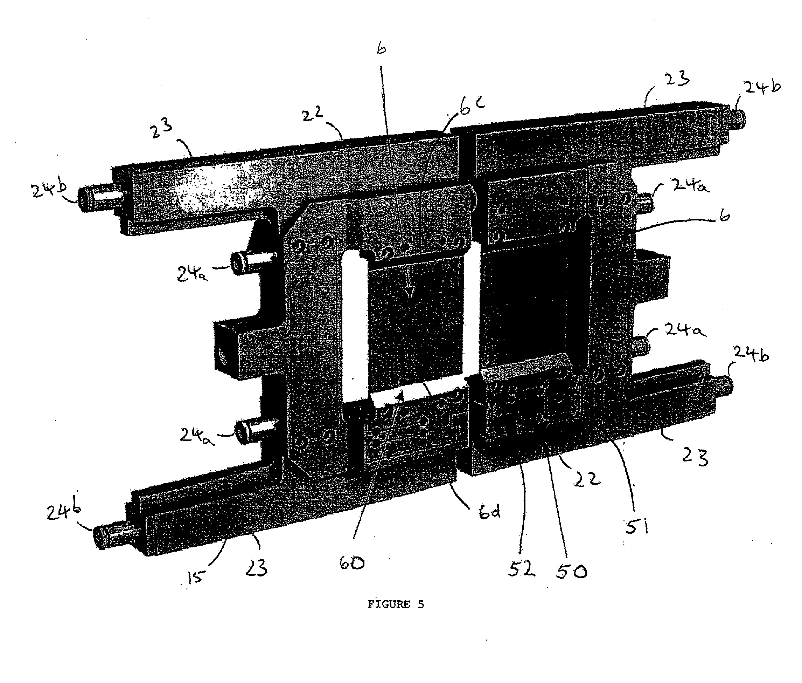

Figure 5 shows the X blades 6 mounted on a first blade support member 15 which provides support to the blades. The support member 15 comprises a U-shaped member 22, wherein opposite edges 6c, 6d of each blade are supported by opposite arms of the U-shaped member. The support member 15 also includes portions 23 extending from the bottom of each corner of the U-shape. To support two blades, two U-shaped members together form an H-shaped member. Cooling means 24a are provided in the support member 15. In particular, liquid, for example, water, cooling is provided by cooling ducts 24a, although, the ducts could also be used for gas cooling. In one embodiment, ducts 24b may supply gas to the gas bearings of the X blades. It is commented that the gas supplied by ducts 24b also contributes to cooling of the blades. In the embodiment shown in Figure 5, the gas ducts 24b are disposed further from the blade than the water cooling ducts 24a. In particular, the gas and liquid ducts 24a, 24b are substantially parallel ducts disposed on opposite sides of support member 15 . In addition to, or optionally to the cooling means described above, the support member 15 may be provided with additional features which enable the masking device to exhibit an improved reaction to thermal stress, including thermal cycling. Support member 15 may be provided with movement limiting means 50 which minimize movement of the support member, such as flexing, bending etc, during thermal stress. The movement limiting means 50 comprise features 51, 52 formed in the support member 15. The features may take various forms and configurations. In the embodiment shown in Figure 5, the features comprise slots 52 joined at hinges 51. The hinges 51 are formed by holes bored into the support member 15. The features provide the structure with a certain degree of flexibility. It has been shown that by arranging the movement limiting means in a particular way, the support member's reaction to thermal stress is moderated significantly. The dimensions and configurations of the features, such as the slots and wings will depend on factors such as the materials of the support member and the thermal stress characteristics. Also provided on the support member 15 are clamping means 60. The clamping means comprises one or more fingers which extend from the support member 15 to clamp the blade.

Figure 6 shows further embodiments of the X-blades mounted on a first support member 15. As described with reference to Figure 5, opposite edges 6c, 6d of the X-blade 6 are mounted on opposite arms of the U-shaped support member 15. The motor magnets 2 are mounted on a magnet support member 63. The magnet support member 63 comprises a portion disposed between the opposite arms of the U-shaped support member 15. In Figure 6, the two magnets 2 are shown, which are part of the motor (not shown in its entirety) which drives the blades. Also provided on support member 15 is a cooling structure 16, 69, 24. The cooling structure 16, 69, 24 comprises portions 16 mounted on each arm of the support member 15, inlet 69 through which coolants may be introduced into the coolant structure 16, 69, 24. The structure is provided with coolant ducts 24 (shown in dotted lines) extending through the coolant structure, preferably along the length of the coolant structure. Also provided is a connecting conduit for connecting the coolant ducts in each cooling portion 16 mounted on each arm of the support member 15. One of the cooling inlets 69 may also function as a cooling outlet 69 to allow the circulated coolant to leave the structure 16, 24. The cooling means may provide cooling by various fluid coolants, both gases and liquids. A preferred coolant is water.

The portions of the cooling structure are provided on the supporting member 15 to preferably align with the opposing edges 6c, 6d of the X-blade, respectively. In the embodiment shown in Figure 6, the X-blade is supported directly by the cooling structures 16. However, the invention is not limited in this respect, and the X-blades may be supported by the frame of the support member. Also provided on the support member to clamp the blade in place is a clamping device 17. The clamping device 17 comprises a plurality of resilient means arranged in use to attach to a surface of the X-blade along the edge 6c, 6d of the X-blade in the X direction. The resilient means comprise an L shaped spring which exerts a force downwards through the blade in the Z-direction. Lateral movement in the X-direction is prevented by the provision of a further clamping means 20, 21. Clamping means 20, 21 comprises a stop 20 and a resilient means 21 disposed at opposite edges 6e, 6f of the X-blade in the X-direction, wherein resilient means 21 is arranged to exert a force on the X-blade in the X-direction towards stop 20. The resilient means 21 may comprise a spring and the stop 20 may comprise a fixed anvil. In Figure 6 resilient means 21 is configured from a flat portion material. An L-shaped cut is provided in the flat piece of material to provide resiliency. It will be appreciated that the resiliency of the clamping means can be determined according to the choice of material and the dimensions of the cut in the portion. It has been found that the combined clamping effect in the Z-direction by clamping device 17 and in the X-direction by clamping device 20, 21 provide stable and accurate retention of the X-blade. In particular, the X-blade is prevented from moving forward in the X direction.

It has been found that it is important to provide good thermal conductivity between the X-blade, which is subject to large thermal stresses, and the slider, and that clamping of the blade to the slider must be effective and secure regardless of any thermal expansion experienced by the slider, the blade and any clamping components. For the Y-blades, the term "slider" refers to the Y-blades themselves. For the X-blades, the term "slider" refers to the blade support member, of which the blades are a part. It has further been found that satisfying these two conditions causes problems in conventional masking assemblies. To overcome this problem, in a preferred embodiment, a double sided clamping mechanism is provided as shown in Figure 6. In this embodiment, the X-blade is clamped with clamping devices 17 on both sides of its support member 15, as discussed above. Clamping device 17 clamps the upper surface of the X-blade. This arrangement provides the advantage that thermal expansion of the clamping and clamped components is compensated equally in the X-direction, whilst keeping the blade securely clamped, and hence accurately aligned. In a further preferred embodiment, a layer of silver foil is disposed between the blade and the cooling body. The silver layer has good thermal conductivity. This arrangement provides a further particular advantage of reducing the hot spot temperature whilst maintaining good thermal contact between the blade and the cooling body. The hot spot is defined as being the center of the blade, and is located in the vicinity of reference number 6. The arrangement shown in Figure 6 allows the blade to expand in the Y-direction between clamps 17 disposed on either side. This means that under thermal load, the front edge of the blade 6e remains substantially in the same position in the X-direction, thus maintaining a sharp shadow projection. Thus, under thermal load, the X-blade exhibits almost no noticeable deterioration in the accuracy of its masking performance.

Also shown in Figure 6 are blade dampers 18 disposed on the respective ends of opposite arms of the support member 15, which are in the form of buffers, which function to lessen or absorb the shock of any disturbance exerted on the support member 15. The support member 15 is also provided with gas bearings (not shown) on the rear side of the support member. Also provided are gas bearing preload strips 62, which are used to preload the gas bearing provided on the support member 15. The gas bearing preload strips 62 are preferably made of a metal, such as iron. In the housing in which the masking device is disposed, adjacent the support member 15, in the stationary portion of the housing, there is provided magnets which can form part of the gas bearings. The magnets are arranged in the housing so as to exert a force on the preload strips 62. The gas bearing exerts an opposite force to that exerted by the magnets. Thus, by providing a constant magnetic force and a constant gas pressure, a well defined stiffness of the gas bearings is achieved.

Figure 7 provides a plan view of a second support member 70 for the Y-blades 4a, 4b showing in particular a gas bearing which is in use supports the Y-blades and the cooling structures. Y-blades 4a and 4b are shown in dotted outline disposed in a recess 79 formed in the second support member 70. Also shown in the centre of the recess 79 is an outline of a through hole 82 formed in the support member 70 through which the projection beam passes (and over which the Y-blades move in part). Also shown in Figure 7 is detail of the gas bearing which supports the Y-blades. A gas inlet 71 is provided in the support member 70. Gas is introduced through the inlet 71 and passes through duct 80 formed in the support member 70. A slightly raised portion 74 is formed on the floor of the recess 79. The duct 80 is connected to openings 75 formed in the raised portion 74. When gas is introduced into inlet 71 the Y blade disposed in recess 79 is supported by the gas leaving openings 75. In use, the Y-blade is uncoupled from the support member 70. Thus, it is not susceptible to friction between it and the support member 70. This allows the Y-blades to be moved using less energy, and thus allows the Y-blades to be accelerated at increased rates. As shown in Figure 7, a plurality of gas bearings may be provided. The Y-blades are mechanically isolated, in use, from the machine.

The scanning Y blades require cooling. The blades are guided with gas bearings as described above. The second supporting member 70 comprises a gas bearing surface 76. The gas bearing surface is stationary and is fluid cooled by a cooling system 72, 73, 81. The Y-blades are also cooled by the cooling system 72, 73, 81. Fluid coolant, preferably water, is introduced through inlet 72 formed in support member 70. The fluid is fed to outlet 73 formed in the support member 70 via a duct 81. The duct is preferably configured in the support member 70 to transverse the width of the Y-blade when disposed in said recess. In use, the gas bearing causes the Y-blade to be raised above the floor of the support structure by approximately 10-20 micrometers. Heat conduction takes place from the blades through the gap formed between the underside of the blades and the gas bearing surface 76 of the cooled gas bearing. The advantage of this particular arrangement is that the Y blades can be satisfactorily cooled without the provision of gas or liquid hoses connected to the moving blade. This benefits the lifetime and accuracy of the masking device, as well as reduces the moving mass of the Y-blade assembly.

In a further preferred embodiment, the X-blades are controlled to act as a heat shield in the case of the Y-blades becoming overheated. For example, if the Y-blades are disposed in a closed arrangement, whilst the X-blades are disposed in an open or partially open arrangement, the projection beam will impinge fully or partially (depending on the distance between the X-blades) on the Y-blades. This may cause the Y-blades to overheat. However, in addition it may cause the gas bearing described with reference to Figure 7 to be damaged. To prevent this from occurring, the X-blades are controlled to move to block the light impinging on the Y-blades. In particular, for a particular dosage, if light impinges on the Y-blades for longer than a predetermined time duration, the controller will cause the X-blades to move into a position which shades the Y-blades from the optical source. In this way the X-blades function as a thermal shield to protect the Y-blades. As described previously, the X-blades are constructed to be robust with respect to the projection beam, being able to withstand the full impact of the projection beam without suffering adverse effects.

It will be appreciated with reference to Figures 5, 6 and 7, that the first and second masking means are arranged in the apparatus, mechanically uncoupled with respect to each other. In particular, the first and second support members are mechanically uncoupled. Preferably, the X-blade and Y-blade assemblies are modular units. The X-blade assembly and the Y-blade assembly are two separate modules that are assembled and tested independently from one another. The complete modules are assembled with respect to one another as shown in Figures 2-4 and 8 for use. To do this certain parts of the X-blade assembly and Y-blade assembly are coupled to each other. However, it is not necessary to couple the X blades with respect to the Y blades. This provides an advantage that disturbances including vibrations caused by the movement of the X blades do not affect the Y-blades, and vice versa. Thus, the masking assembly is easier to assemble and test than conventional assemblies. In particular, separate components can be assembled and tested without having to disassemble the entire assembly. This saves time and man hours.

It has been found that during operation electrostatic charge may build up in the lithographic apparatus. This may have a detrimental effect on certain sensors and electronic circuits. To overcome this problem, in a preferred embodiment, at least one of the blades is provided with an electrostatic discharge rod which conducts electrostatic charge towards it, and thus away from sensitive sensors and electronics. This arrangement has an advantage of protecting electrostatic sensitive components. The rod may be disposed on either the X or the Y or both blades. However, preferably, the rod is disposed on the Y blades. Preferably, it comprises a thin tapered rod mounted on one of the blades. Its dimensions and material are chosen to provide optimum electrostatic conduction whilst having a minimum mass. The rod may, by way of example, be made of copper.

The motors for driving the blades are controlled by software which comprises a list of instructions to control the motors. In conventional blade assemblies, it is known for blades to collide with one another. This may not only damage the blades but will affect production if the apparatus is shut down for repairs. In a preferred embodiment, sensors are provided which detect the position of the blades and provide feedback to the control means. The software which provides the instructions to the motors is adapted to take account of the sensed position data, and is designed to preclude the possibility that the blades come into contact with each other. In this way, the control software which drives the motors prevents collision of the moving X or Y blades, and further collision between an X and a Y blade.

As mentioned previously with reference to Figures 3 a and 3b, it may be necessary to adjust the position of the blades in the Z-direction in order to align the blades correctly with respect to the focal plane and other components. Conventionally, this is achieved by moving the entire assembly comprising the X and Y blade assemblies over the frame that supports them. This is inconvenient and cumbersome.

Figure 8 shows an embodiment of the present invention detailing features which overcome this problem. In particular, Figure 8 shows a manipulator screw 25 for manipulating the position of the X and Y blades in the Z-direction, that is in the direction of the optical axis. A frame 27 is provided within the X and Y assemblies as shown in Figures 6 and 7, respectively, are mounted. The X and Y assemblies are denoted by reference numeral 28 in Figure 8, and are supported by frame 27. The projection beam projects through opening 31 in the Z direction. It is seen that the Z-manipulator screw 25, when turned, exerts a force on a base plate 26, which is provided with manipulator hinges. The frame 27 supporting the X and Y (sub) assemblies remains fixed on its own supporting frame. Preferably, the Z-direction manipulator 25 is integrated in the frame 27.

In particular, the Z manipulator is an adjusting means that comprises a screw 25 which acts on a resilient member, which in turn exerts force in the Z-direction on the X- and Y- assemblies 28. Also provided is a Z manipulator locking screw 29 and a further Z manipulator locking device 30, which maintain the X- and Y- assemblies in the desired location in the Z direction once the desired position has been achieved.

It has been found that it is important that the blades, in particular the X-blade which is usually disposed upstream of the Y-blade, does not come into contact with the end of the quartz rod of the integrator IN, because if it were to, the quartz rod may become damaged. To overcome this problem, a sensor is provided in the vicinity of the downstream end of the quartz rod to sense if the blade comes within a predetermined distance of the exit surface of the quartz rod. If the sensor detects that the blade is within the predetermined distance of the exit surface, the detected signal may be used by an operator to control the Z manipulator to move the blade away from the exit surface in the Z direction. This arrangement improves the reliability of the apparatus, and reduces the risk of damaging the integrator IN.

Whilst specific embodiments of the invention have been described above, it will be appreciated that the invention may be practiced otherwise than as described. The description is not intended to limit the invention. The invention is defined by the claims.

## Claims

1. A lithographic projection apparatus comprising:
an illumination system (IL) for providing a projection beam (PB) of radiation, wherein said illumination system (IL) defines a focal plane through which, in use, said projection beam (PB) passes;
a support structure (MT) for supporting a patterning means (MA) at a location, the patterning means (MA) serving to pattern the projection beam (PB) according to a desired pattern;
a masking device (MD) for obscuring at least a part of said patterning means (MA) from said projection beam (PB), said masking device (MD) comprising a first masking means (6) arranged to obscure said part in a first direction with respect to said location and a second masking means (4) arranged to obscure said part in a second different direction with respect to said location;
a substrate table (WT) for holding a substrate (W);
a projection system (PB) for imaging the patterned beam onto a target portion of the substrate (W), **characterized in that** said first and second masking means are disposed in the vicinity of said focal plane in a mechanically uncoupled arrangement with respect to each other and
each of said first and second masking means (4,6) is supported on respective separate first and
second support members (15,70), wherein the second support member (70) comprises a gas bearing surface (76) and an opening (75) and in use gas is leaving the opening (75) to create a gas bearing between the gas bearing surface and a movable blade provided to the second masking means to support the blade.

2. A lithographic projection apparatus according to any of the preceding claims, wherein said first masking means (6) is provided with cooling means (16,19,24).

3. A lithographic projection apparatus according to claim 2, wherein said cooling means (16,19,24) comprises a cooling structure (24) which is incorporated into said first support member (15).

4. A lithographic projection apparatus according to claim 3, wherein said cooling structure (24) includes an inlet (19) through which a cooling fluid is introduced, a cooling duct (24) through which said cooling fluid passes, and an outlet (19) through which said cooling fluid exits said cooling structure (1 6,19,24).

5. A lithographic projection apparatus according to any of the preceding claims 2-4, wherein said cooling means (1 6,19,24) provides water cooling.

6. A lithographic projection apparatus according to any of the preceding claims 2-5, wherein said second masking means (4) is provided with cooling means (72) and wherein said first masking means (6) and said second masking means (4) are cooled to a different degree with respect to each other.

7. A lithographic projection apparatus according to any of the preceding claims 1-6, wherein said first masking means (6) comprises a blade (6) mounted on said blade support (1 5), wherein a layer of material (18) having a high thermal conductivity is disposed between said blade (6) and said blade support (1 5).

8. A lithographic projection apparatus according to claim 7, wherein said material is silver.

9. A lithographic projection apparatus according to any of the preceding claims, wherein said first masking means (6) comprises a blade having a thickness in the direction of the projection beam of less than 0.5 mm.

10. A lithographic projection apparatus according to any of the preceding claims, wherein said first and second masking means (4,6) comprise first and second pairs of moveable blades, respectively.

11. A lithographic projection apparatus according to any of the preceding claims, wherein said first masking means (6) comprises a plate made of one of the materials selected from a group comprising: chemical vapour deposition diamond, aluminium, tungsten copper alloy and silicon carbide.

12. A lithographic projection apparatus according to any of the preceding claims, wherein said first and second masking means (6,4) are driven by non-contact linear motors, respectively.

13. A lithographic projection apparatus according to claim 12, wherein said second masking means (4) are provided with a magnet which form part of said respective non-contact linear motor.

14. A lithographic projection apparatus according to any of the preceding claims, wherein said first and second masking means (6,4) comprise a pair of blades arranged to move together and apart in the X and Y-direction, respectively.

15. A lithographic projection apparatus according to claim 1, wherein said gas bearing (71,80) cools said second masking means.

16. A lithographic projection apparatus according to claim 15, wherein said support member (70) further comprising a cooling structure (72,73,81) to cool said gas bearing surface (76).

17. A lithographic projection apparatus according to claim 16, wherein said cooling structure (72,73,81) comprises an inlet (71) through which a coolant is introduced, a duct (80) through which said coolant passes and an outlet through which said coolant exits said structure.

18. A lithographic projection apparatus according to any of the preceding claims 15-17, wherein heat is conducted from said second masking means (4) via a gap provided by said gas bearing between said second masking means (4) and said second support member (70).

19. A lithographic projection apparatus according to any of the preceding claims, wherein said first masking means (6), when disposed in a closed position, acts as a shutter to protect said second masking means (4) from said projection beam (PB).

20. A lithographic projection apparatus according to any of the preceding claims, wherein said first masking means (6) and said second masking means (4) are modular units.

21. A lithographic projection apparatus according to any of the preceding claims, wherein at least one of said masking means (6,4) is provided with an electrostatic discharge device.

22. A lithographic projection apparatus according to claim 21, wherein said electrostatic discharge device comprises a rod mounted on a blade of at least one of said masking means (4,6), so as to direct an electrostatic charge away from particular components of the apparatus.

23. A lithographic projection apparatus according to any of the preceding claims, wherein a pair of
blades of any of said masking means (4,6) are controlled by a controlling means to avoid collision between each blade of the pair.

24. A lithographic projection apparatus according to any of preceding claims 1-23, wherein said support members (15,70) are provided with adjustment means (25,24,30) for adjusting the position of said first and second masking means (6,4) in the direction of the projection beam (PB).

25. A lithographic projection apparatus according to claim 24, wherein said adjustment means comprises a screw (25) which acts on a resilient member, said screw (25) and said resilient member being mounted on a frame (27).

26. A lithographic projection apparatus according to any of the preceding claims, wherein the second direction defines a scanning direction in the Y-direction, the first direction defining a nonscanning direction in the X direction, said X direction being substantially perpendicular to said Y direction.

27. A lithographic projection apparatus according to any of the preceding claims 1-26 wherein said first masking means (6) includes a blade and said apparatus further includes a clamping means (17) provided at two opposite ends of the blade for clamping said blade to said blade support (15) such that said blade is supported at said opposite ends by said blade support.

28. A lithographic projection apparatus according to any of the preceding claims, wherein any of said masking means (6,4) are provided with an anti-reflective coating.

29. A lithographic projection apparatus according to any of the preceding claims, wherein the masking means (6,4) comprises a masking plate having a composition including CVD diamond or tungsten, copper alloy or silicon carbide.

30. A device manufacturing method comprising the steps of:
providing a substrate that is at least partially covered by a layer of radiation-sensitive material;
providing a projection beam of radiation using an illumination system;
providing a support structure for supporting a patterning means at a location, the patterning means
serving to pattern the projection beam according to a desired pattern;
selectively obscuring part of at least one of said patterning means from said projection beam and
the patterned beam, using a first masking means to selectively obscure said part in a first direction with respect to said location, and using a second masking means to selectively obscure said part in a second different direction with respect to said location,
projecting the patterned beam of radiation onto a target area of the layer of radiation-sensitive material, **characterized by**
disposing said first masking means and second masking means in the vicinity of a focal plane of said projection beam in a mechanically uncoupled arrangement with respect to one another; supporting each of said first and second masking means (4,6) on respective separate first and second support members (15,70) ) and providing gas through an opening in a gas bearing surface of the second support member to create a gas bearing between the gas bearing surface and a blade provided to the second masking means to support the blade.

## Patentansprüche

1. Ein lithographisches Projektionsgerät, das Folgendes beinhaltet:
ein Beleuchtungssystem (IL) zum Bereitstellen eines Projektionsstrahls (PB) aus Strahlung, wobei das Beleuchtungssystem (IL) eine Brennebene definiert, durch die der Projektionsstrahl (PB) bei Gebrauch geht;
eine Stützstruktur (MT) zum Stützen eines Musteraufbringungsmittels (MA) an einer Stelle, wobei das Musteraufbringungsmittel (MA) dazu dient, den Projektionsstrahl (PB) gemäß einem gewünschten Muster zu mustern;
eine Maskiervorrichtung (MD) zum Verdecken mindestens eines Teils des Musteraufbringungsmittels (MA) vor dem Projektionsstrahl (PB), wobei die Maskiervorrichtung (MD) ein erstes Maskiermittel (6), das eingerichtet ist, um den Teil mit Bezug auf die Stelle in einer ersten Richtung zu verdecken, und ein zweites Maskiermittel (4), das eingerichtet ist, um den Teil mit Bezug auf die Stelle in einer zweiten, unterschiedlichen Richtung zu verdecken, beinhaltet;
einen Substrattisch (WT) zum Halten eines Substrats (W);
ein Projektionssystem (PB) zum Abbilden des gemusterten Strahls auf einem Zielabschnitt des Substrats (W), **dadurch gekennzeichnet, dass** das erste und
zweite Maskiermittel in einer mit Bezug aufeinander mechanisch nicht gekoppelten Anordnung in der Nähe der Brennebene angeordnet sind und jedes von dem ersten und zweiten Maskiermittel (4, 6) auf einem jeweiligen separaten ersten und zweiten Stützelement (15, 70) gestützt wird, wobei das zweite Stützelement (70) eine Gaslageroberfläche (76) und eine Öffnung (75) beinhaltet und das Gas bei Gebrauch die Öffnung (75) verlässt, um zwischen der Gaslageroberfläche und
einem dem zweiten Maskiermittel bereitgestellten beweglichen Blatt ein Gaslager zu erzeugen, um das Blatt zu stützen.

2. Lithographisches Projektionsgerät gemäß einem der vorhergehenden Ansprüche, wobei das erste Maskiermittel (6) mit einem Kühlmittel (16, 19, 24) versehen ist.

3. Lithographisches Projektionsgerät gemäß Anspruch 2, wobei das Kühlmittel (16, 19, 24) eine Kühlstruktur (24) beinhaltet, die in das erste Stützelement (15) inkorporiert ist.

4. Lithographisches Projektionsgerät gemäß Anspruch 3, wobei die Kühlstruktur (24) einen Einlass (19), durch den ein Kühlfluid eingeführt wird, einen Kühlkanal (24), durch den das Kühlfluid geht, und einen Auslass (19), durch den das Kühlfluid aus der Kühlstruktur (16, 19, 24) austritt, umfasst.

5. Lithographisches Projektionsgerät gemäß einem der vorhergehenden Ansprüche 2-4, wobei das Kühlmittel (16, 19, 24) Wasserkühlung bereitstellt.

6. Lithographisches Projektionsgerät gemäß einem der vorhergehenden Ansprüche 2-5, wobei das zweite Maskiermittel (4) mit einem Kühlmittel (72) versehen ist und wobei das erste Maskiermittel (6) und das zweite Maskiermittel (4) mit Bezug aufeinander zu einem unterschiedlichen Grad gekühlt werden.

7. Lithographisches Projektionsgerät gemäß einem der vorhergehenden Ansprüche 1 - 6, wobei das erste Maskiermittel (6) ein Blatt (6) beinhaltet, das an der Blattstütze (15) montiert ist, wobei eine Schicht aus Material (18) mit einer hohen Wärmeleitfähigkeit zwischen dem Blatt (6) und der Blattstütze (15) angeordnet ist.

8. Lithographisches Projektionsgerät gemäß Anspruch 7, wobei das Material Silber ist.

9. Lithographisches Projektionsgerät gemäß einem der vorhergehenden Ansprüche, wobei das erste Maskiermittel (6) ein Blatt mit einer Dicke in der Richtung des Projektionsstrahls von weniger als 0,5 mm beinhaltet.

10. Lithographisches Projektionsgerät gemäß einem der vorhergehenden Ansprüche, wobei das erste und zweite Maskiermittel (4, 6) ein erstes bzw. zweites Paar bewegliche Blätter beinhalten.

11. Lithographisches Projektionsgerät gemäß einem der vorhergehenden Ansprüche, wobei das erste Maskiermittel (6) eine Platte beinhaltet, die aus einem der Materialien gefertigt ist, welche aus einer Folgendes beinhaltenden Gruppe ausgewählt sind: Diamant aus chemischer Gasphasenabscheidung, Aluminium, Wolframkupferlegierung und Siliciumcarbid.

12. Lithographisches Projektionsgerät gemäß einem der vorhergehenden Ansprüche, wobei das erste und zweite Maskiermittel (6, 4) jeweils von berührungslosen Linearmotoren angetrieben werden.

13. Lithographisches Projektionsgerät gemäß Anspruch 12, wobei die zweiten Maskiermittel (4) mit einem Magneten, die einen Teil des jeweiligen berührungslosen Linearmotors bilden, versehen sind.

14. Lithographisches Projektionsgerät gemäß einem der vorhergehenden Ansprüche, wobei das erste und zweite Maskiermittel (6, 4) ein Paar Blätter beinhalten, die eingerichtet sind, um sich in der X- bzw. Y-Richtung zusammen und auseinander zu bewegen.

15. Lithographisches Projektionsgerät gemäß Anspruch 1, wobei das Gaslager (71, 80) das zweite Maskiermittel kühlt.

16. Lithographisches Projektionsgerät gemäß Anspruch 15, wobei das Stützelement (70) ferner eine Kühlstruktur (72, 73, 81) zum Kühlen der Gaslageroberfläche (76) beinhaltet.

17. Lithographisches Projektionsgerät gemäß Anspruch 16, wobei die Kühlstruktur (72, 73, 81) einen Einlass (71), durch den ein Kühlmedium eingeführt wird, einen Kanal (80), durch den das Kühlmedium geht, und einen Auslass, durch den das Kühlmedium aus der Struktur austritt, beinhaltet.

18. Lithographisches Projektionsgerät gemäß einem der vorhergehenden Ansprüche 15-17, wobei
Wärme aus dem zweiten Maskiermittel (4) über eine von dem Gaslager bereitgestellte Lücke zwischen dem zweiten Maskiermittel (4) und dem zweiten Stützelement (70) geleitet wird.

19. Lithographisches Projektionsgerät gemäß einem der vorhergehenden Ansprüche, wobei das erste Maskiermittel (6), wenn in einer geschlossenen Position angeordnet, als Verschluss wirkt, um das zweite Maskiermittel (4) vor dem Projektionsstrahl (PB) zu schützen.

20. Lithographisches Projektionsgerät gemäß einem der vorhergehenden Ansprüche, wobei das erste Maskiermittel (6) und das zweite Maskiermittel (4) modulare Einheiten sind.

21. Lithographisches Projektionsgerät gemäß einem der vorhergehenden Ansprüche, wobei mindestens eines der Maskiermittel (6, 4) mit einer Vorrichtung für elektrostatische Entladung versehen ist.

22. Lithographisches Projektionsgerät gemäß Anspruch 21, wobei die Vorrichtung für elektrostatische Entladung einen an einem Blatt von mindestens einem der Maskiermittel (4, 6) montierten Stab beinhaltet, um eine elektrostatische Ladung von bestimmten Komponenten des Geräts wegzulenken.

23. Lithographisches Projektionsgerät gemäß einem der vorhergehenden Ansprüche, wobei ein Paar Blätter von einem beliebigen der Maskiermittel (4, 6) durch ein Steuermittel gesteuert wird, um eine Kollision zwischen jedem Blatt des Paares zu vermeiden.

24. Lithographisches Projektionsgerät gemäß einem der vorhergehenden Ansprüche 1 - 23, wobei die Stützelemente (15, 70) mit einem Einstellungsmittel (25, 24, 30) versehen sind, um die Position des ersten und zweiten Maskiermittels (6, 4) in der Richtung des Projektionsstrahls (PB) einzustellen.

25. Lithographisches Projektionssystem gemäß Anspruch 24, wobei das Einstellungsmittel eine Schraube (25) beinhaltet, die auf ein elastisches Element wirkt, wobei die Schraube (25) und das elastische Element an einem Rahmen (27) montiert sind.

26. Lithographisches Projektionsgerät gemäß einem der vorhergehenden Ansprüche, wobei die zweite Richtung eine Scanrichtung in der Y-Richtung definiert, wobei die erste Richtung eine Nicht-Scanrichtung in der X-Richtung definiert, wobei die X-Richtung zu der Y-Richtung im Wesentlichen senkrecht ist.

27. Lithographisches Projektionsgerät gemäß einem der vorhergehenden Ansprüche 1 - 26, wobei das erste Maskiermittel (6) ein Blatt umfasst und das Gerät ferner ein Klemmmittel (17) umfasst, das an zwei gegenüberliegenden Enden des Blattes bereitgestellt ist, um das Blatt an die Blattstütze (15) zu klemmen, so dass das Blatt an den gegenüberliegenden Enden von der Blattstütze gestützt wird.

28. Lithographisches Projektionsgerät gemäß einem der vorhergehenden Ansprüche, wobei beliebige der Maskiermittel (6, 4) mit einer Antireflexbeschichtung versehen sind.

29. Lithographisches Projektionsgerät gemäß einem der vorhergehenden Ansprüche, wobei das Maskiermittel (6, 4) eine Maskierplatte mit einer Zusammensetzung, die CVD-Diamant oder Wolfram, Kupferlegierung oder Siliciumcarbid umfasst, beinhaltet.

30. Ein Verfahren zum Herstellen einer Vorrichtung, das die folgenden Schritte beinhaltet:
Bereitstellen eines Substrats, das mindestens teilweise von einer Schicht aus strahlungsempfindlichem Material bedeckt ist;
Bereitstellen eines Projektionsstrahls aus Strahlung unter Verwendung eines Beleuchtungssystems;
Bereitstellen einer Stützstruktur zum Stützen eines Musteraufbringungsmittels an einer Stelle, wobei das Musteraufbringungsmittel dazu dient, den Projektionsstrahl gemäß einem gewünschten Muster zu mustern;
selektives Verdecken eines Teils von mindestens einem von dem Musteraufbringungsmittel vor dem Projektionsstrahl und dem gemusterten Strahl unter Verwendung eines ersten Maskiermittels, um den Teil in einer ersten Richtung mit Bezug auf die Stelle selektiv zu verdecken und unter Verwendung eines zweiten Maskiermittels, um den Teil in einer zweiten, unterschiedlichen Richtung mit Bezug auf die Stelle selektiv zu verdecken,
Projizieren des gemusterten Strahls aus Strahlung auf einen Zielbereich der Schicht aus strahlungsempfindlichem Material, **gekennzeichnet durch** Anordnen des erste Maskiermittels und des zweiten Maskiermittels in der Nähe einer Brennebene des Projektionsstrahls in einer mechanisch nicht gekoppelten Anordnung mit Bezug aufeinander;
Stützen jedes des ersten und zweiten Maskiermittels (4, 6) auf einem jeweiligen ersten und zweiten Stützelement (15, 70) und Bereitstellen von Gas **durch** eine Öffnung in einer Gaslageroberfläche des zweiten Stützelements, um zwischen der Gaslageroberfläche und einem dem zweiten Maskiermittel bereitgestellten Blatt, ein Gaslager zu erzeugen, um das Blatt zu stützen.

## Revendications

1. Un appareil de projection lithographique comprenant :
un système d'illumination (IL) destiné à fournir un faisceau de projection (PB) de rayonnement, ledit système d'illumination (IL) définissant un plan focal au travers duquel ledit faisceau de projection (PB) passe, lors de l'utilisation ;
une structure formant support (MT) destinée à supporter un moyen pour conformer selon un motif (MA) au niveau d'un emplacement, le moyen pour conformer selon un motif (MA) servant à conformer le faisceau de projection (PB) selon un motif souhaité ;
un dispositif de masquage (MD) destiné à occulter au moins une partie dudit moyen pour conformer selon un motif (MA) par rapport audit faisceau de projection (PB),
ledit dispositif de masquage (MD) comprenant un premier moyen de masquage (6) arrangé pour occulter ladite partie dans une première direction par rapport audit emplacement et un deuxième moyen de masquage (4) arrangé pour occulter ladite partie dans une deuxième direction, différente de la première, par rapport audit emplacement ;
une table porte-substrat (WT) pour porter un substrat (W) ;
un système de projection (PB) destiné à imager le faisceau à motif sur une portion cible du substrat (W), **caractérisé en ce que** lesdits premier et deuxième moyens de masquage sont disposés au voisinage dudit plan focal suivant un arrangement où ils sont mécaniquement non couplés l'un par rapport à l'autre et chacun desdits premier et deuxième moyens de masquage (4, 6) est supporté sur des premier et
deuxième éléments de support distincts respectifs (15, 70), dans lequel le deuxième élément de support (70) comprend une surface de palier à gaz (76) et un orifice (75) et, lors de l'utilisation, du gaz quitte l'orifice (75) afin de créer un palier à gaz entre la surface de palier à gaz et une lame mobile prévue sur le deuxième moyen de masquage pour supporter la lame.

2. Un appareil de projection lithographique selon n'importe lesquelles des revendications précédentes, dans lequel ledit premier moyen de masquage (6) est pourvu d'un moyen de refroidissement (16, 19, 24).

3. Un appareil de projection lithographique selon la revendication 2, dans lequel ledit moyen de refroidissement (16, 19, 24) comprend une structure de refroidissement (24) qui est incorporée dans ledit premier élément de support (15).

4. Un appareil de projection lithographique selon la revendication 3, dans lequel ladite structure de refroidissement (24) comporte une entrée (19) par laquelle un fluide de refroidissement est introduit, une canalisation de refroidissement (24) dans laquelle ledit fluide de refroidissement passe, et une sortie (19) par laquelle ledit fluide de refroidissement se retire de ladite structure de refroidissement (16, 19, 24).

5. Un appareil de projection lithographique selon n'importe lesquelles des revendications précédentes 2 à 4, dans lequel ledit moyen de refroidissement (16, 19, 24) fournit un refroidissement par l'eau.

6. Un appareil de projection lithographique selon n'importe lesquelles des revendications précédentes 2 à 5, dans lequel ledit deuxième moyen de masquage (4) est pourvu d'un moyen de refroidissement (72) et dans lequel ledit premier moyen de masquage (6) et ledit deuxième moyen de masquage (4) sont refroidis à un degré différent l'un par rapport à l'autre.

7. Un appareil de projection lithographique selon n'importe lesquelles des revendications précédentes 1 à 6, dans lequel ledit premier moyen de masquage (6) comprend une lame (6) montée sur ledit support de lame (15), une couche de matériau (18) à forte conductivité thermique étant disposée entre ladite lame (6) et ledit support de lame (15).

8. Un appareil de projection lithographique selon la revendication 7, dans lequel ledit matériau est l'argent.

9. Un appareil de projection lithographique selon n'importe lesquelles des revendications précédentes, dans lequel ledit premier moyen de masquage (6) comprend une lame qui présente une épaisseur dans la direction du faisceau de projection faisant moins de 0,5 mm.

10. Un appareil de projection lithographique selon n'importe lesquelles des revendications précédentes, dans lequel lesdits premier et deuxième moyens de masquage (4, 6) comprennent des première et deuxième paires de lames mobiles, respectivement.

11. Un appareil de projection lithographique selon n'importe lesquelles des revendications précédentes, dans lequel ledit premier moyen de masquage (6) comprend une plaque réalisée en un des matériaux sélectionnés dans un groupe comprenant : le diamant déposé par voie chimique en phase vapeur, l'aluminium, l'alliage cuivre-tungstène, et le carbure de silicium.

12. Un appareil de projection lithographique selon n'importe lesquelles des revendications précédentes, dans lequel lesdits premier et deuxième moyens de masquage (6, 4) sont mus par des moteurs linéaires sans contact, respectivement.

13. Un appareil de projection lithographique selon la revendication 12, dans lequel lesdits deuxièmes moyens de masquage (4) sont pourvus d'un aimant qui font partie dudit moteur linéaire sans contact respectif.

14. Un appareil de projection lithographique selon n'importe lesquelles des revendications précédentes, dans lequel lesdits premier et deuxième moyens de masquage (6, 4) comprennent une paire de lames arrangées pour se rapprocher et s'écarter dans la direction X et Y, respectivement.

15. Un appareil de projection lithographique selon la revendication 1, dans lequel ledit palier à gaz (71, 80) refroidit ledit deuxième moyen de masquage.

16. Un appareil de projection lithographique selon la revendication 15, dans lequel ledit élément de support (70) comprend en outre une structure de refroidissement (72, 73, 81) pour refroidir ladite surface de palier à gaz (76).

17. Un appareil de projection lithographique selon la revendication 16, dans lequel ladite structure de refroidissement (72, 73, 81) comprend une entrée (71) par laquelle un liquide de refroidissement est introduit, une canalisation (80) dans laquelle ledit liquide de refroidissement passe et une sortie par laquelle ledit liquide de refroidissement se retire de ladite structure.

18. Un appareil de projection lithographique selon n'importe lesquelles des revendications précédentes 15 à 17, dans lequel
la conduction de chaleur depuis ledit deuxième moyen de masquage (4) se fait via un intervalle fourni par ledit palier à gaz entre ledit deuxième moyen de masquage (4) et ledit deuxième élément de support (70).

19. Un appareil de projection lithographique selon n'importe lesquelles des revendications précédentes, dans lequel ledit premier moyen de masquage (6), lorsque disposé dans une position fermée, fait office d'obturateur pour protéger ledit deuxième moyen de masquage (4) dudit faisceau de projection (PB).

20. Un appareil de projection lithographique selon n'importe lesquelles des revendications précédentes, dans lequel ledit premier moyen de masquage (6) et ledit deuxième moyen de masquage (4) sont des unités modulaires.

21. Un appareil de projection lithographique selon n'importe lesquelles des revendications précédentes, dans lequel au moins l'un desdits moyens de masquage (6, 4) est pourvu d'un dispositif de décharge électrostatique.

22. Un appareil de projection lithographique selon la revendication 21, dans lequel ledit dispositif de décharge électrostatique comprend une tige montée sur une lame d'au moins l'un desdits moyens de masquage (4, 6), de manière à diriger une charge électrostatique à l'écart de composants particuliers de l'appareil.

23. Un appareil de projection lithographique selon n'importe lesquelles des revendications précédentes, dans lequel une paire de lames de n'importe lesquels desdits moyens de masquage (4, 6) sont contrôlées par un moyen de contrôle pour éviter une collision entre chaque lame de la paire.

24. Un appareil de projection lithographique selon n'importe lesquelles des revendications précédentes 1 à 23, dans lequel lesdits éléments de support (15, 70) sont pourvus de moyens d'ajustement (25, 24, 30) pour ajuster la position desdits premier et deuxième moyens de masquage (6, 4) dans la direction du faisceau de projection (PB).

25. Un appareil de projection lithographique selon la revendication 24, dans lequel ledit moyen d'ajustement comprend une vis (25) qui agit sur un élément résilient, ladite vis (25) et ledit élément résilient étant montés sur un cadre (27).

26. Un appareil de projection lithographique selon n'importe lesquelles des revendications précédentes, dans lequel la deuxième direction définit une direction de balayage dans la direction Y, la première direction définissant une direction de non balayage dans la direction X, ladite direction X étant substantiellement perpendiculaire à ladite direction Y.

27. Un appareil de projection lithographique selon n'importe lesquelles des revendications précédentes 1 à 26, dans lequel ledit premier moyen de masquage (6) comporte une lame et ledit appareil comporte en outre un moyen d'ablocage (17) fourni au niveau de deux extrémités opposées de la lame pour abloquer ladite lame sur ledit support de lame (15) de telle sorte que ladite lame soit supportée au niveau desdites extrémités opposées par ledit support de lame.

28. Un appareil de projection lithographique selon n'importe lesquelles des revendications précédentes, dans lequel n'importe lesquels desdits moyens de masquage (6, 4) sont pourvus d'un revêtement anti-réfléchissant.

29. Un appareil de projection lithographique selon n'importe lesquelles des revendications précédentes, dans lequel le moyen de masquage (6, 4) comprend une plaque de masquage ayant une composition comportant du diamant CVD ou du tungstène, un alliage de cuivre ou du carbure de silicium.

30. Un procédé de fabrication de dispositif comprenant les étapes consistant à :
fournir un substrat qui est au moins partiellement recouvert d'une couche de matériau sensible au rayonnement ;
fournir un faisceau de projection de rayonnement à l'aide d'un système d'illumination ;
fournir une structure de support pour supporter un moyen pour conformer selon un motif au niveau d'un emplacement, le moyen pour conformer selon un motif servant à conformer le faisceau de projection selon un motif souhaité ;
occulter de manière sélective une partie au moins soit dudit moyen pour conformer selon un motif par rapport audit faisceau de projection, soit du faisceau à motif, à l'aide d'un premier moyen de masquage pour occulter de manière sélective ladite partie dans une première direction par rapport audit emplacement, et à l'aide d'un deuxième moyen de masquage pour occulter de manière sélective ladite partie dans une deuxième direction, différente de la première, par rapport audit emplacement,
projeter le faisceau de rayonnement à motif sur une zone cible de la couche de matériau sensible au rayonnement, **caractérisé par** le fait de disposer ledit premier moyen de masquage et ledit deuxième moyen de masquage au voisinage d'un plan focal dudit faisceau de projection suivant un arrangement où ils sont mécaniquement non couplés l'un par rapport à l'autre ;
supporter chacun desdits premier et deuxième moyens de masquage (4, 6) sur des premier et deuxième éléments de support distincts respectifs (15, 70), et
fournir du gaz par un orifice dans une surface de palier à gaz du deuxième élément de support afin de créer un palier à gaz entre la surface de palier à gaz et une lame prévue sur le deuxième moyen de masquage pour supporter la lame.
